(19) Europäisches Patentamt
European Patent Office
Office européen des brevets

(11) **EP 3 794 157 B1**

(12) **EUROPEAN PATENT SPECIFICATION**

(45) Date of publication and mention
of the grant of the patent:
**16.03.2022 Bulletin 2022/11**

(21) Application number: **19710317.9**

(22) Date of filing: **27.02.2019**

(51) International Patent Classification (IPC):
*H05H 1/50* *(2006.01)*     *H05H 1/46* *(2006.01)*
*H01J 37/34* *(2006.01)*     *H01J 37/32* *(2006.01)*
*C23C 14/58* *(2006.01)*     *C23C 14/34* *(2006.01)*
*C23C 14/00* *(2006.01)*

(52) Cooperative Patent Classification (CPC):
**C23C 14/0078; C23C 14/3492; C23C 14/5826;
C23C 14/5873; H01J 37/32082; H01J 37/3405;
H01J 37/3464; H01J 37/3467; H05H 1/4645;**
H05H 1/50; H05H 2242/20

(86) International application number:
**PCT/EP2019/054856**

(87) International publication number:
**WO 2019/219255 (21.11.2019 Gazette 2019/47)**

(54) **METHOD OF TREATING A SUBSTRATE AND VACUUM DEPOSITION APPARATUS**

VERFAHREN ZUR BEHANDLUNG EINES SUBSTRATS UND
VAKUUMABSCHEIDUNGSVORRICHTUNG

PROCÉDÉ DE TRAITEMENT D'UN SUBSTRAT ET APPAREIL DE DÉPÔT SOUS VIDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.05.2018 CH 6142018**

(43) Date of publication of application:
**24.03.2021 Bulletin 2021/12**

(73) Proprietor: **Evatec AG**
**9477 Trübbach (CH)**

(72) Inventors:
• **SCHÜNGEL, Edmund**
**9470 Buchs (CH)**
• **GEES, Silvio**
**7310 Bad Ragaz (CH)**

(74) Representative: **Troesch Scheidegger Werner AG**
**Schwäntenmos 14**
**8126 Zumikon (CH)**

(56) References cited:
**EP-A1- 0 699 246**     **WO-A1-2014/187939**
**US-A- 5 690 796**     **US-A1- 2015 110 968**
**US-A1- 2018 087 142**

## Description

The invention addressed herein relates to a method of treating a substrate in a vacuum environment, the method including a material deposition on the substrate. Under further aspects, the invention relates to a vacuum deposition apparatus adapted to perform the method.

Processes for deposition of thin layers on a substrate are e.g. applied in the production of optical coatings. Such processes are typically performed in a vacuum environment. A material deposition on the substrate may involve the generation of a plasma, such as in the case of sputter deposition. In addition to the actual deposition step, a growing layer may be treated in the plasma of a second plasma source in the same vacuum environment, e.g. in the plasma of a so-called etching source, also referred to as surface treatment plasma source. A substrate may be repetitively and alternatingly exposed to one of the two plasma sources.

However, the operation of two plasma sources in the same vacuum environment has several drawbacks. Process parameters, such as ion energies or current densities of one plasma may depend on the presence or absence and actual properties of the other plasma. The simultaneous operation of two plasma sources may induce process drifts, which do not occur during the operation of the individual sources alone.

US2015110968 is part of the prior art on the subject-matter.

The object of the present invention is to provide a method, which overcomes at least one of these drawbacks.

This object is achieved by a method according to claim 1. The method according to the invention is a method of vacuum-treating a substrate or of manufacturing a vacuum-treated substrate. The method comprises the steps:

- Providing a vacuum chamber.
- Providing at least one substrate in the vacuum chamber.
- Generating a plasma environment in the vacuum chamber and exposing the at least one substrate to the plasma environment, wherein the plasma environment comprises a first plasma of a material deposition source on the at least one substrate and a second plasma of a non-deposition source.
- Operating the plasma environment repeatedly between a first and a second state,

the first state being defined by:
a higher plasma supply power to the first plasma causing a higher material deposition rate and a lower plasma supply power delivered to the second plasma, the second state being defined by:

a lower supply power to the first plasma, compared with the higher supply power to the first plasma and causing a lower material deposition rate and a higher supply power to the second plasma, compared with the lower supply power to the second plasma.

The inventors have recognized that with this method, process drifts are reduced. This has the effect that the treatment of the substrate is more effective as the time spent in conditions close to the desired process parameters is increased. The inventors have recognized that the feasible process window, in particular with regard to ion energies and ion current densities, is widened by operating a plasma environment according to the method of the present invention. The inventors have further recognized that undesired interactions between a first plasma in a material deposition area and a second plasma in a non-deposition plasma treatment area may successfully be reduced by applying the method.

The basic principle of the method lies in repeatedly alternating between two power supply states involving both plasmas and by synchronizing the alternating, such that the above defined first and second state are repeatedly realized during operating the plasma environment. In the first state a first higher plasma supply power is delivered to the first plasma and a second lower plasma supply power is delivered to the second plasma. In the second state, the situation is inverted, i.e. a first lower plasma supply power is delivered to the first plasma and a second higher plasma supply power is delivered to the second plasma. First/second lower and first/second higher plasma supply power is in each case defined with respect to the higher plasma supply power to the first plasma and the higher plasma supply power to the second plasma, respectively. First and second lower plasma supply power may be lower than a power needed to sustain the respective plasma. The lower plasma supply power to the first plasma and/or the lower plasma supply power to the second plasma may be zero power.

According to the method, at least one substrate is provided in the plasma environment. There may be a multiplicity of substrates in the plasma environment. In the latter case, individual substrates may simultaneously or successively receive a material deposition caused by the first plasma.

The method may be described as a method of surface deposition and treatment with an alternating source operation scheme.

The alternating source operation scheme affects a common plasma environment of at least two plasma sources. By the term plasma environment, we refer to the space in which one or more plasma sources have an effect or make an impact when operated.

Variants of the method are defined by the features of claims 2 to 11.

In one embodiment of the method according to the invention, which may be combined with any of the preaddressed variants and any of the variants still to be addressed unless in contradiction, the plasma environment is operated periodically repeatedly between the first and the second state, with a varying or constant period.

Periodic operation between the first and second state may be achieved by simple means and may be controlled by a small number of parameters.

In one variant of the method according to the invention, which may be combined with any of the variants still to be addressed unless in contradiction, the method comprises establishing a treatment time span, during which the at least one substrate is exposed to the plasma environment, and wherein during at least 90% of the treatment time span, preferably during at least 99% of the treatment time span, exclusively one of the first state and of the second state prevails.

This way, in a predominant fraction of the treatment time span, the higher power plasma supply state of the first plasma has no temporal overlap with the higher power plasma supply state of the second plasma. The inventors have recognized, that an efficient decoupling of the two plasmas can be achieved this way. Operating conditions of one plasma are less dependent on operating conditions of the other plasma. This opens the way for operating the first and second plasma not only in the same vacuum chamber, but also in spatial proximity.

One variant of the method according to the invention, which may be combined with any of the preaddressed variants and any of the variants still to be addressed unless in contradiction, comprises maintaining at least a part of the at least one substrate in the plasma environment while moving the at least one substrate relative to the plasma environment.

The inventors have recognized that by applying the method of this variant, layers of homogeneous thickness and low roughness can be deposited on a substrate. Moving may include rotating the at least one substrate around an axis. Moving may include translational or rotational movements across the plasma environment, as well as a combination of such movements. Moving may include moving the at least one substrate from a position, where the first plasma causes a high material deposition to a position, where the second plasma has high intensity. The moving may be carried out by moving a substrate holder, which holds one or several substrates. The substrate holder, may e.g. rotate around a rotation axis with a rotational speed of 10 to 240 rotations per minute, such that each substrate repeatedly passes the same position in time intervals of 0.25 to 6 seconds. A movement of the substrate relative to the plasma environment may alternatively be achieved by moving other parts than the substrate, in particular parts of the plasma sources, such that the location of the plasma environment is in relative motion with respect to the substrate.

In one variant of the method according to the invention, which may be combined with any of the preaddressed variants and any of the variants still to be addressed unless in contradiction, the plasma environment is operated periodically repeatedly between the first and the second state, with a varying or constant period, and the period T is selected to be:

$$2 \ \mu sec \leq T \leq 50 \ \mu sec.$$

With such a short period T, corresponding to a repetition rate in the 20 kHz to 500 kHz range, no synchronizing of the alternating between the first state and the second state with other slower process, such as moving a substrate, is necessary. Even for a substrate in motion, both, first and second state of the plasma environment are effective for every position along its trajectory.

One variant of the method according to the invention, which may be combined with any of the preaddressed variants and any of the variants still to be addressed unless in contradiction, comprises operating of the plasma environment additionally in a third state, the third state being defined by simultaneously delivering the higher plasma supply power to the first plasma and the higher plasma supply power to the second plasma.

Going from the first state to the second state via the third state may help to ignite the second plasma, in case the lower plasma supply power to the second plasma did not sustain the second plasma during the first state. Accordingly, going from the second state to the first state via the third state may help to ignite the first plasma, in case the lower plasma supply power to the first plasma did not sustain the first plasma during the second state. During the ignition phase of the first or second plasma, a faster ramp up of the respective ion current may be achieved when the third state is established at least for a short time span. Furthermore, a risk of occasional failure of the ignition of a plasma may be reduced by the present variant. Even in cases where a reignition of the plasma is not necessary, the presence of the third state in between the first and second state may help to faster reach stable operating conditions after a change of state. The time span during which the third state prevails may be shorter than the time span during which the first state prevails or be shorter than the time span during which the second state prevails.

In one variant of the method according to the invention, which may be combined with any of the preaddressed variants and any of the variants still to be addressed unless in contradiction, the method comprises exposing a first treatment area for the substrate in the plasma environment at least predominantly to the first plasma and exposing a second treatment area for the substrate in the plasma environment at least predominantly to the second plasma.

In one variant of the method according to the invention, which may be combined with any of the preaddressed variants and any of the variants still to be addressed unless in contradiction, there further prevails:

- the first treatment area coincides with the second treatment area or

- the first treatment area and the second treatment area overlap or

- the first treatment area is within the second treatment area or

- the second treatment area is within the first treatment area or

- said first and second treatment areas are commonly exposed to the plasma environment.

With the method of the present invention, a variety of spatial arrangements of the first and the second treatment area are possible. Due to the method of the invention, a significant decoupling of the first and second plasma over time enables an overlap of the first and second treatment areas in space or even a coinciding of first and second treatment areas.

In one variant of the method according to the invention, which may be combined with any of the preaddressed variants and any of the variants still to be addressed unless in contradiction, the method further comprises:

- exposing at least a part of the at least one substrate to the first treatment area during more than one repetition of the operating and then
- moving at least the part of the substrate into the second treatment area.

The inventors have recognized that the present variant enables a treatment of the substrate, wherein a succession of plasma deposition and non-deposition plasma treatment is required, in an efficient way. The part of the at least one substrate is kept long enough in the first treatment area, i.e. in a plasma-deposition area, that it is exposed at least once to the higher material deposition rate caused by the first plasma during the first state, before it undergoes a step of the non-deposition plasma treatment in the second treatment area.

In one variant of the method according to the invention, which may be combined with any of the preaddressed variants and any of the variants still to be addressed unless in contradiction, the method further comprises - exposing at least the part to the second treatment area during more than one repetition.

The part of the at least one substrate is kept long enough in the second treatment area, i.e. the non-deposition plasma-treatment area, that it is exposed at least once to the second plasma during the delivering of the higher plasma supply power to the second plasma, before it undergoes a step of the plasma-deposition again.

In one variant of the method according to the invention, which may be combined with any of the preaddressed variants and any of the variants still to be addressed unless in contradiction, the method comprises etching the at least one substrate in the second treatment area at least enhanced by the second plasma.

Plasma etching or plasma surface treatment is a non-depositing process step, i.e. plasma etching makes use of a plasma adapted to non-establish deposition of a material on a substrate. In the so-called plasma assisted deposition process, plasma etching, or plasma enhanced etching caused by the second plasma may improve layer quality when applied alternatingly with a deposition step. In particular, a very low roughness of a layer produced by a deposition process combined with an etching process may be achieved. The method according to the present variant keeps the operating conditions for plasma etching very stable. The method according to the present variant allows to perform plasma etching in an area close to the first treatment are, i.e. close to a material deposition area, or even in an area overlapping with the first treatment area, i.e. overlapping with a material deposition area. A material deposition process involving a plasma and a plasma etching process can be decoupled in time by applying the present method.

In one variant of the method according to the invention, which may be combined with any of the preaddressed variants and any of the variants still to be addressed unless in contradiction, the method comprises performing by means of the first plasma one of physical vapor deposition (PVD) and of plasma enhanced chemical vapor deposition (PECVD).

PVD as well as PECVD processes are suited to deposit a material on the at least one substrate. Both types of process are suited for producing optical coatings on a substrate, in particular for producing very smooth multi-layer coatings. The quality of the resulting product of both types of process benefits from a combination with a non-depositing plasma treatment, particularly from a plasma etching treatment, as defined in a previous variant.

In one variant of the method according to the invention, which may be combined with any of the preaddressed variants and any of the variants still to be addressed unless in contradiction, the first plasma is the plasma of a sputtering source, preferably of a magnetron sputtering source.

Plasma sputter deposition processes according to the variant of the method are suited to deposit a material on the at least one substrate. They are suited for producing optical coatings on a substrate, in particular for producing very smooth multi-layer coatings. The quality of the resulting product benefits from a combination with a non-depositing plasma treatment, particularly from a plasma etching treatment, as defined in a previous variant, too.

In one variant of the method according to the invention, which may be combined with any of the preaddressed variants and any of the variants still to be addressed unless in contradiction, at least one of the first and of the second plasma is operated in an atmosphere comprising a reactive gas.

In one variant of the method according to the invention, which may be combined with any of the preaddressed variants and any of the variants still to be addressed unless in contradiction, the lower plasma supply power to the first plasma is established by supplying the first plasma with at most vanishing supply power.

In this variant the lower plasma supply power to the first plasma is set to essentially zero power during the second state. This reduces a possible influence onto the second plasma, which receives the higher plasma supply power during the second state, to a minimum. According to this variant, the plasma supply power to the first plasma is switched between "on" and "off". This variant of the method may be implemented by interrupting a connection between a generator supplying the first plasma for a time span (e.g. by actuating a switch at a power output of the generator). It may be implemented by shutting down a generator supplying the first plasma during a time span (e.g. by actuating a control switch). It may also may be implemented by reducing the output power level of a generator supplying the first plasma to a very low value. It may also be implemented by reversing the polarity of the output power of a generator supplying the first plasma. Reversing the polarity has the effect that charging effects on the target surface are minimized.

In one variant of the method according to the invention, which may be combined with any of the preaddressed variants and any of the variants still to be addressed unless in contradiction, the lower plasma supply power to the second plasma is established by supplying the second plasm with at most vanishing supply power.

In this variant the lower plasma supply power to the second plasma is set to essentially zero power during the first state. This reduces a possible influence onto the first plasma, which receives the higher plasma supply power during the first state, to a minimum. According to this variant, the plasma supply power to the second plasma is switched between "on" and "off". This variant of the method may be implemented by interrupting a connection between a generator supplying the second plasma for a time span (e.g. by actuating a switch at a power output of the generator). It may be implemented by shutting down a generator supplying the second plasma during a time span (e.g. by actuating a control switch). It may also may be implemented by reducing the output power level of a generator supplying the second plasma to a very low value.

In one variant of the method according to the invention, which may be combined with any of the preaddressed variants and any of the variants still to be addressed unless in contradiction, the method comprises operating the plasma environment periodically repeatedly between the first and the second state, with a varying or constant period thereby establishing the higher plasma supply power to the second plasma simultaneously with the higher plasma supply power to the first plasma during a time span $\Delta$, which is shorter than the period T of the operating.

In one variant of the method according to the invention, which may be combined with any of the preaddressed variants and any of the variants still to be addressed unless in contradiction, a varying or constant period T of the operating the plasma environment repeatedly is selected to be:

$$2 \ \mu sec \ \leq \ T \ \leq \ 50 \ \mu sec,$$

a third state of the operating being enabled for a third time span t3 for which there is valid:

$$0 \ \mu sec \ < \ t3 \ \leq \ 2 \ \mu sec.$$

In one variant of the method according to the invention, comprises operating the plasma environment additionally in a third state, defined by simultaneously delivering the higher plasma supply power to the first plasma and the higher plasma supply power to the second plasma and comprising operating the plasma environment still additionally in a fourth state defined by simultaneously delivering the first lower plasma supply power to the first plasma and the second lower plasma supply power to the second plasma.

In one variant of the method according to the invention, which may be combined with any of the preaddressed variants and any of the variants still to be addressed unless in contradiction, the method comprises operating the plasma environment periodically repeatedly between the first and the second state, thereby establishing the higher plasma supply power to the second plasma simultaneously with the higher plasma supply power to the first plasma during a time span $\Delta$, which is shorter than the period T of the operating.

In one variant of the method according to the invention, which may be combined with any of the preaddressed variants and any of the variants still to be addressed unless in contradiction, the method comprises establishing the fourth state during a fourth time span t4 for which there is valid:

$$0 \ \mu sec \ < \ t4 \ \leq \ 2 \ \mu sec.$$

In one variant of the method according to the invention, which may be combined with any of the preaddressed variants and any of the variants still to be addressed unless in contradiction, the method comprises exposing a first treatment area for the substrate in the plasma environment at least predominantly to the first plasma and exposing a second treatment area for the substrate in the plasma environment at least predominantly to the second plasma and positioning simultaneously a first part of the at least one substrate exclusively in the first treatment area and a different, second part of the at least one substrate exclusively in the second treatment area.

In one variant of the method according to the invention, which may be combined with any of the preaddressed variants and any of the variants still to be addressed unless in contradiction, the method comprises positioning a further different part of the at least one substrate in an overlapping area of the first and second treatment areas.

In one variant of the method according to the invention, which may be combined with any of the preaddressed variants and any of the variants still to be addressed unless in contradiction, the method comprises exposing a first treatment area for the substrate in the plasma environment at least predominantly to the first plasma and exposing a second treatment area for the substrate in the plasma environment at least predominantly to the second plasma and positioning simultaneously a part of a first substrate exclusively in the first area and a part of a second substrate exclusively in the second treatment area.

In one variant of the method according to the invention, which may be combined with any of the preaddressed variants and any of the variants still to be addressed unless in contradiction, the method comprises positioning a further part of the first substrate in an overlapping area of the first treatment area and of the second treatment area, simultaneously with positioning the one part of the first substrate exclusively in the first treatment area.

In one variant of the method according to the invention, which may be combined with any of the preaddressed variants and any of the variants still to be addressed unless in contradiction, the method comprises positioning a further part of the second substrate in an overlapping area of the first treatment area and of the second treatment area, simultaneously with positioning the one part of the second substrate exclusively in the first treatment area.

In one variant of the method according to the invention, which may be combined with any of the preaddressed variants and any of the variants still to be addressed unless in contradiction, the method comprises operating the plasma environment periodically repeatedly between the first and the second state, with a varying or constant period T, and a first duty cycle DC1 defined as the ratio of time span during which the first state is enabled and the period of the operating, is kept within the range: $25\% \leq DC1 \leq 90\%$.

In one variant of the method according to the invention, which may be combined with any of the preaddressed variants and any of the variants still to be addressed unless in contradiction, the method comprises operating the plasma environment periodically repeatedly between the first and the second state, with a varying or constant period T, and a second duty cycle DC2 defined as the ratio of time span during which the second state is enabled and the period of the operating, is kept within the range: $25\% \leq DC2 \leq 95\%$.

In one variant of the method according to the invention, which may be combined with any of the preaddressed variants and any of the variants still to be addressed unless in contradiction, the method comprises exposing a first treatment area for the substrate in the plasma environment at least predominantly to the first plasma and exposing a second treatment area for the substrate in the plasma environment at least predominantly to the second plasma and establishing a gas atmosphere in the first and second treatment areas comprising equal gas or gases or consisting of equal gas or gases.

In one variant of the method according to the invention, which may be combined with any of the preaddressed variants and any of the variants still to be addressed unless in contradiction, at least one of a further plasma adapted to deposit a material on the at least one substrate and of a further plasma adapted to non-deposit a material on the at least one substrate is provided.

The invention is further directed to a vacuum deposition apparatus according to claim 12.

The vacuum deposition apparatus according to the invention comprises:

- a vacuum chamber, in the vacuum chamber a material deposition first treatment area and a material non-deposition second treatment area,

- a drivingly movable substrate holder at least one of movable between the first treatment area and the second treatment area and of movable within at least one of the first treatment area and the second treatment area,

- a first plasma source generating a first plasma at least predominantly in the first treatment area,

- a second plasma source generating a second plasma at least predominantly in the second treatment area,

- a controllable first electric plasma supply arrangement, operationally connected to the first plasma source comprising a first control input to control different supply power levels,

- a controllable second electric plasma supply arrangement operationally connected to the second plasma source and comprising a second control input to control different supply power levels, and

- a control arrangement operationally connected to the control inputs,

wherein the control arrangement is constructed to first control via the first control input the first electric plasma supply to repeatedly supply a first higher, plasma sustaining power level and a first lower power level,
wherein the control arrangement is constructed to second control via the second control input the second electric plasma supply to repeatedly supply a second higher, plasma sustaining power level and a second lower power level, and wherein the control arrangement is further constructed to time-synchronize the first and second controls.

The vacuum deposition apparatus according to the invention is adapted to perform the method according to the invention. In particular, the control arrangement is adapted to control the timing of a switching between the power levels of the first and second electric plasma supply arrangement in a synchronized way, such that the first and second state according as defined in the method can be realized. The control arrangement may comprise a network for transmitting control signals, such as start and stop signals. Such control signals may be transmitted as electrical signal, radio-frequency signal or optical signal. The control arrangement may comprise a central control unit.

In short, the apparatus may be described as a vacuum deposition apparatus adapted to perform an alternating source operation scheme.

Embodiments of the apparatus are defined by the features of claims 13 to 17.

In one embodiment of the apparatus according to the invention, which may be combined with any of the preaddressed embodiments and any of the embodiments still to be addressed unless in contradiction, the first and second treatment areas are a common area or the first and second treatment areas overlap or the first and second treatment areas are in open communication.

In the present embodiment, the first and second treatment have a mutual spatial orientation, which enables them to be in a common plasma environment of a first plasma and a second plasma.

In one embodiment of the apparatus according to the invention, which may be combined with any of the preaddressed embodiments and any of the embodiments still to be addressed unless in contradiction, there is valid at least one of:

- the first electric plasma supply arrangement is a controlled DC power supply arrangement,

- the second power supply is a controlled RF power supply.

In one embodiment of the apparatus according to the invention, which may be combined with any of the preaddressed embodiments and any of the embodiments still to be addressed unless in contradiction, the control arrangement controls a temporal overlap of the first higher power level and of the second lower power level and a temporal overlap of the first lower power level and of the second higher power level.

In one embodiment of the apparatus according to the invention, which may be combined with any of the preaddressed embodiments and any of the embodiments still to be addressed unless in contradiction, the control arrangement is adapted and configured to synchronize an operating between a first state and a second state as defined in the method according to the invention.

In one embodiment of the apparatus according to the invention, which may be combined with any of the preaddressed embodiments and any of the embodiments still to be addressed unless in contradiction, the first plasma source is a pulsed DC magnetron source, in particular a pulsed DC magnetron source with superimposed RF.

In one embodiment of the apparatus according to the invention, which may be combined with any of the preaddressed embodiments and any of the embodiments still to be addressed unless in contradiction, the first plasma source comprises a rotatable magnet arrangement and/or a rotatable target.

The first plasma source may apply a rotating magnet, wherein the rotating magnet arrangement provides a magnetic field traversing the first plasma. The first plasma source may be used to sputter material from target, which rotates relative to a sputtering zone.

In one embodiment of the apparatus according to the invention, which may be combined with any of the preaddressed embodiments and any of the embodiments still to be addressed unless in contradiction, the substrate holder is adapted to hold a plurality of substrates, in particular, the substrate holder is designed as table or as drum rotatable around a respective central axis.

This embodiment is useful for coating a plurality of substrates. Several substrates may be arranged along a common circle around a central rotation axis of the substrate holder being designed as a rotating table. A plurality of substrates may be attached to a cylindrical surface of a drum, rotating about its cylinder axis. Each individual substrate may sequentially undergo a treatment in one or several material deposition stations and one or several non-depositing plasma treatment stations arranged along a common circle along the table surface or around the drum. In addition, each substrate may individually rotate around its own axis in order to improve layer homogeneity.

In one embodiment of the apparatus according to the invention, which may be combined with any of the preaddressed embodiments and any of the embodiments still to be addressed unless in contradiction, the substrate holder being adapted to hold two neighboring substrates in the plurality of substrates in a distance from each other, the distance being smaller than or equal to a distance between the first treatment area and the second treatment area.

The invention shall now be further exemplified with the help of figures. The figures show:

Fig. 1 a schematic cross-section of a vacuum chamber and a substrate in two different states realized in the method according to the invention;

Fig. 2 a state diagram illustrating an operating of a plasma environment between a first and a second state;

Fig. 3, in six sub-figures 3.a) to 3.f), six individual state diagrams illustrating variants of an operating of a plasma environment between a first and a second state and involving a third and/or fourth state;

Fig. 4 a schematic cross-section of a vacuum chamber and a substrate in four different states realized in in an embodiment of the method;

Fig. 5 a timing diagram showing a time course of a power delivered to a first plasma and of a power delivered to a second plasma in an embodiment of the method;

Fig. 6 a timing diagram showing a time course of a power delivered to a first plasma and of a power delivered to a second plasma in a further embodiment of the method;

Fig. 7 a timing diagram showing a time course of a power delivered to a first plasma and of a power delivered to a second plasma in a further embodiment of the method;

Fig. 8 a schematic diagram of an embodiment of the apparatus according to the invention;

Fig. 9, in subfigures Fig. 9.a) and Fig. 9.b), the time-dependency of voltages measured at the first and second source during two variants of the method according to the invention;

Fig. 10 the time-dependency of voltages measured at the first and second source during a method according the state of the art.

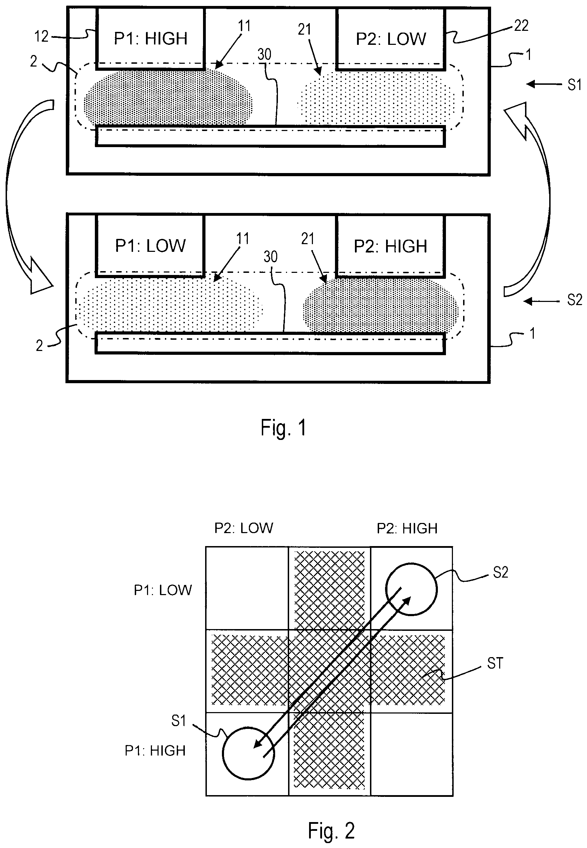

Fig. 1 shows schematically and simplified, cross-section of a vacuum chamber and a substrate in two different states, one in the upper part and one in the lower part of the figure. In both states, a substrate 30 is positioned in a vacuum chamber 1 and exposed to a plasma environment 2. A first plasma 11 is adapted to deposit a material on the substrate. A second plasma 21 is adapted to non-deposit a material on the at least one substrate, i.e. to treat the substrate in a way that does not lead to deposition of a material. The first plasma 11 can be operated with a higher or a lower plasma power as indicated in the symbolically shown first plasma source 12 by "P1: HIGH" for the higher power and by "P1: LOW" for the lower power. Similarly, the second plasma 21 can be operated with a higher or a lower plasma power as indicated in the symbolically shown second plasma source 22 by "P2: HIGH" for the higher power and by "P2: LOW" for the lower power. According to the method of the invention, the plasma environment 2 is repeatedly operated between a first state S1, as shown in the upper part of the figure, and a second state S2, as shown in the lower part of the figure. The curved arrows on the left and the right of the figure indicate a repeated alternating between the two states.

In the first state S1, a higher plasma supply power is delivered to the first plasma. This causes a higher material deposition rate, as symbolically indicated by the high density of dots. Simultaneously, a lower plasma supply power is delivered to the second plasma, which is indicated by a low density of dots. In the second state S2, a higher plasma supply power, i.e. higher compared to the lower plasma supply power delivered in the first state, is delivered to the second plasma. Simultaneously, a lower plasma supply power is delivered to the first plasma. The power is lower compared with the higher plasma supply power as delivered to the first plasma during the first state. The lower plasma supply power delivered to the first plasma causes a lower material deposition rate. This is symbolically indicated by a lower density of dots in the region of the first plasma 11.

The plasma environment 2 is schematically indicated by a region surrounded by a dash-dotted line. Its borders may not be sharply defined. Anyhow, the plasma environment 2 forms a continuous region inside the vacuum chamber.

Fig. 2 shows a state diagram illustrating an operating of a plasma environment between a first and a second state. The states involved are defined by the amount of power delivered to the first and the second plasma, respectively. In horizontal rows the plasma supply power to the first plasma is indicated, whereas in vertical rows the plasma supply power to the second plasma is indicated. The diagram shows three horizontal rows and three vertical rows. The top horizontal row corresponds to the lower plasma supply power delivered to the first plasma, as marked by "P1: LOW". The bottom horizontal row corresponds to the higher plasma supply power delivered to the first plasma, as marked by "P1: HIGH". The middle horizontal row corresponds to a transitional state of the power delivered to the first plasma. The left vertical row corresponds to the lower plasma supply power delivered to the second plasma, as marked by "P2: LOW". The right vertical row corresponds to the higher plasma supply power delivered to the second plasma, as marked by "P2: HIGH". The middle vertical row corresponds to a transitional state of the power delivered to the second plasma. Five fields in the diagram are marked by cross-hatching. These five fields correspond to transitional power states ST. The first state S1 thus corresponds to the bottom left field of the diagram and the second state S2 of the plasma environment thus corresponds to the top right field of the diagram. According to the invention, the plasma environment comprising the first and the second plasma is operated repeatedly between the first and the second state as indicated by arrows in both directions. The diagram does indicate the succession of states that are reached, but it does not imply any information on the time spent in the first S1 or the second state S2, nor how long it takes to cross the region of transitional state ST.

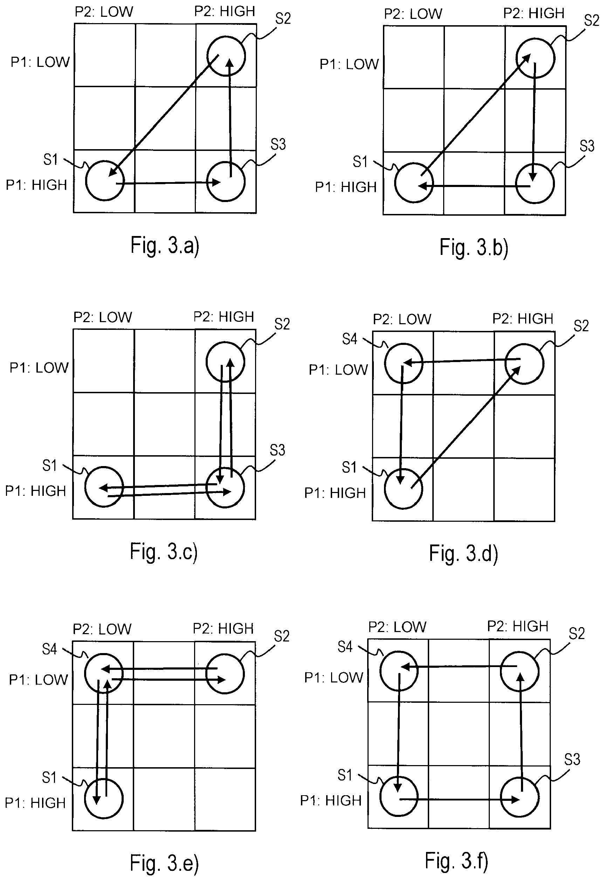

Fig. 3 shows state diagrams similar to the ones explained in relation with Fig. 2. Embodiments of the method are illustrated. The embodiments involve additional states in the succession of states.

Fig. 3.a) shows an embodiment, wherein operating of the plasma environment involves a third state S3, which is defined by simultaneously delivering the higher plasma supply power to the first plasma and the higher plasma supply power to the second plasma. Accordingly, the third state is in the bottom right field of the diagram. In the embodiment of the method illustrated in Fig. 3.a), on the transition from the first state to the second state, the plasma supply power to the first plasma is kept on its higher level, while switching the plasma supply power to the second plasma from its lower lever to its higher level, thereby reaching the third state. In the third state, the second plasma may ignite fast and reproducible, or, if already ignited, reach stable operating conditions fast. In the next step, the plasma supply power to the first plasma is reduced to its lower level, thus reaching the second state. In the embodiment shown, the step from the second state S2 back to the first state S1 is taken directly.

Fig. 3.b) shows a similar embodiment of the method as Fig. 3.a), but in this case, the third state is established on the transition from the second state S2 to the first state S1.

Fig. 3.c) again shows a similar embodiment of the method. In this case, the third state is established on both ways between the first and the second state.

Fig. 3.d) shows an embodiment, wherein operating of the plasma environment involves a fourth state S4, which fourth state is defined by simultaneously delivering the first lower plasma supply power to the first plasma and the second lower plasma supply power to the second plasma. In this fourth state, the first and second plasma run both on the respective lower power level, such that the mutual interaction is particularly low. In the present embodiment, the fourth state is established between the second and the first state.

Fig. 3.e) shows an embodiment, wherein the fourth state is established on both ways when going forth and back between the first and second state.

Fig. 3.f) shows as a further example, an embodiment of the method involving the first, second, third and fourth states as defined above. In the embodiment shown, a sequence of the first state S1, third state S3, second state S2, fourth state S4 and first state S1 (again) is established. Here, during the third state, a higher power level delivered to the first plasma may help to induce a fast ramp up of the second plasma, whereas on the way back to the first state, a clean decoupling may be achieved by switching both plasmas to their lower power level for an intermediate time span, during which the fourth state is established, before reaching the first state again.

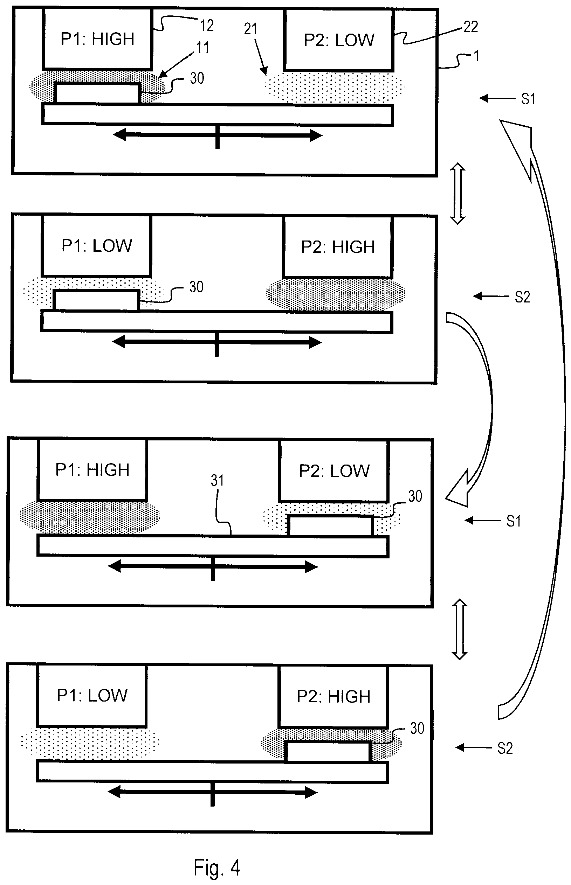

Fig. 4 shows in a simplified manner, similar to Fig. 1, an embodiment of the method comprising moving at least a part of the at least one substrate in the plasma environment.

Specifically, a substrate 30 is positioned on a substrate holder 31, which is rotatable around an axis and thus is able to transport the substrate from a position in the region of the first plasma 11 into a position in the region of the second plasma 21. The plasma environment in the vacuum chamber 1 is switched back and forth between the first state S1 and the second state S2, as indicated by the double arrow between the top and the second partial figure. A moving process may be slow compared to the alternating between the first and second state of the plasma environment. Over a longer time span, as indicated by the curved arrow from the second to the third partial figure, due to the moving, the substrate arrives in the region of the second plasma 21. Irrespective of the position of the substrate, the alternating between the first and the second state of the plasma environment continuous, as shown in the bottom partial figure, where the second state S2 is established again. Over a longer time span, as indicated by the long curved arrow starting at the bottom partial figure, due to the moving, the substrate arrives again in the original position as shown in the top partial figure. Instead of having a complete substrate 30 in the respective position, a part of a large substrate may take the role of the substrate shown here. Several substrates may be placed at various positions of the substrate holder, such that each individual substrate undergoes a similar procedure as the one substrate shown in this figure.

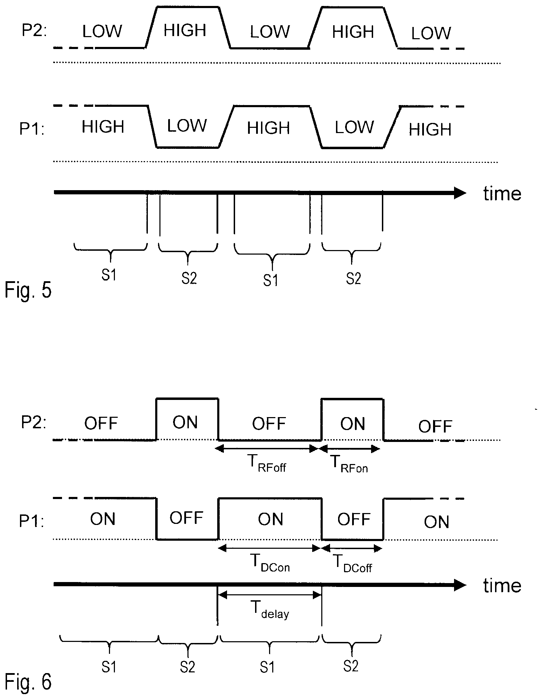

Fig. 5 shows a timing diagram for an operating of the plasma environment. A time axis runs from left to right. A time course of a first power P1 delivered to a first plasma and of a second power P2 delivered to a second plasma is displayed each above its own zero power reference marked as thin line. First and second power alternate repeatedly between a higher and a lower level. For easier identification, the respective time spans are denoted by "HIGH" and "LOW" for both, first and second power. The diagram is schematic and not to scale. In particular, the absolute power levels of the first power, being related to a material deposition, and the second power, being related to a non-depositing, treatment plasma power, may have different orders of magnitude. Some time is needed to switch from one state to the other, leading in this case to a trapezoidal time course of the power levels. Alternatingly, a first state and a second state of the plasma environment is established, as marked below the time axis. The alternating may be periodic. A period T, i.e. a time of one repetition, may e.g. be in the range of 2 to 50 microseconds.

Fig. 6 shows a timing diagram similar to the time diagram shown in Fig. 5. In the present case, the lower power levels delivered to the first and to the second plasma correspond to zero power. Accordingly, the alternating can be seen to switch between an "ON" and an "OFF" value instead of a higher and a lower power. In particular, in the case shown here, the power delivered to the first plasma may be applied in form of a pulsed DC current, the pulsing corresponding to the "ON"/"OFF" power level P1. The second plasma may be applied in form of RF power, e.g. in form of RF having a frequency of 13.56 MHz. A succession of first state S1 and second state S2 is realized. A synchronization of the two states may e.g. be achieved as follows. A first power supply, which may be a DC power supply, and a second power supply, which may be a RF power supply, produce in response to a trigger signal a rectangular output power pulse. During a time span $T_{DCon}$ the first power P1 is "ON", during a subsequent time $T_{DCoff}$ the power P1 is "OFF". During a time span $T_{RFoff}$ the second power P2 is "OFF", during a time span $T_{RFon}$, the second power P2 is "ON". The trigger signal sent to the second power supply may be delayed by $T_{delay}$ with respect to the trigger signal sent to the first power supply. A timing as illustrated in the timing diagram according to Fig. 6 may then be achieved by setting the time spans $T_{DCon}$, $T_{RFoff}$ and $T_{delay}$ to equal values. Similarly, $T_{DCoff}$ and $T_{RFon}$ are set to be equal with respect to each other, but the latter may be different from $T_{DCon}$ etc. This way, time spans during which power is delivered to the first plasma do not overlap with time spans, during which power is delivered to the second plasma.

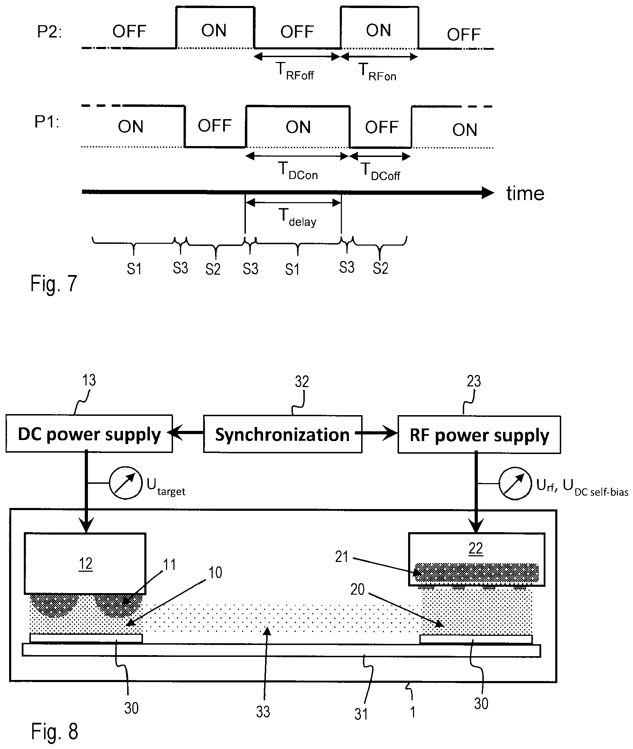

Fig. 7 show s similar timing diagram as Fig. 6. The same notation regarding the time spans is used. In this embodiment, however, the time span $T_{DCon}$ is selected to be slightly longer than $T_{RFoff}$. Furthermore, $T_{delay}$ is selected such that at the beginning of a time span with higher plasma supply power to the first plasma and at the end of this time span, an overlap with a time span with higher plasma supply power to the second plasma is created. I.e. the third state S3 of the plasma environment is established between the occurrence of the first state S1 and the second state S2. If the sequence is made periodic, a period T, which in this case is defined as the sum $T_{DCon} + T_{DCoff}$, may lie in the range of 2 to 50 microseconds. $T_{DCon}$ may be in the range 1 to 48 microseconds. $T_{RFon}$ may be in the range 2 to 48 microseconds. The sum $T_{DCon} + T_{RFon}$ may be larger than the period T due to the time spans, during which the state S3 is established, i.e. during which both "ON" states overlap.

Fig. 8 shows an embodiment of an apparatus according to the invention, schematically and in a partial cross-section. In a vacuum chamber 1, a first plasma source 12 and a second plasma source 22 are provided. The first plasma source 12 creates a first plasma 11. The first plasma 11 is adapted to deposit a material on a substrate 30. In the embodiment shown, the region of the first plasma forms a PVD station. The first plasma source 12 is designed as a magnetron. A first electric plasma supply arrangement 13, in this case a DC power supply, delivers electrical power to the first plasma. A region of dense plasma is indicated by a high density of dots. A second plasma source 22 is driven by an RF power supply, which forms a second electric plasma supply arrangement 23. A second plasma 21 is adapted to treat a substrate in a non-depositing way, e.g. by plasma etching or by applying a compactification treatment by plasma. A dense plasma region in the second plasma 21 is indicated by high density of dots, too. A weak plasma 33, which is in contact with the first and the second plasma, may establish a coupling effect between the first and second plasmas. The weak plasma may comprise ions and/or electrons originating from the first or from the second plasma source. As the inventors have recognized, this coupling or cross-talk may be reduced, may be stopped completely or may be selectively applied to control the process parameters, by applying the method according to the present invention. The method may involve essentially an alternating or "anti-synchronous" operation scheme regarding operating of the first plasma and the second plasma. In the situation illustrated here, the plasma environment comprises the first plasma 11, the second plasma 21 as well as the weak plasma 33.

A substrate holder 31 in form of a table carries substrates 30. In the cross-section shown, two substrates are visible, one substrate 30 in the plasma deposition-area 10 in the region of the first plasma 11, another substrate 30 in the non-deposition plasma treatment area 20 in the region of the second plasma 21. A synchronization unit 32 is operationally connected to power-level control inputs of the first electric plasma supply arrangement and the second electric plasma supply arrangement. The connection may be realized by electrical wire connection or wireless. The synchronization unit and the connections to the electric supplies form a control arrangement. The control arrangement is constructed to control the first supply to alternatingly supply a first higher, plasma sustaining power level and a first lower power level. The control arrangement is constructed to control the second electric plasma supply arrangement to alternatingly supply a second higher, plasma sustaining power level and a second lower power level, and the control arrangement is further constructed to synchronize the supply of the first and of the second electrical supplies.

To explain measured results presented further below, reference is made to the following optional measuring devices. One is for measuring a target voltage $U_{target}$ on the side of the first plasma source. The other is for measuring the rf voltage $U_{rf}$ and a DC self-bias voltage $U_{DC}$ self-bias on the side of the second plasma. Temporal stability of these voltages is an important indicator for the stability of the vacuum deposition processes.

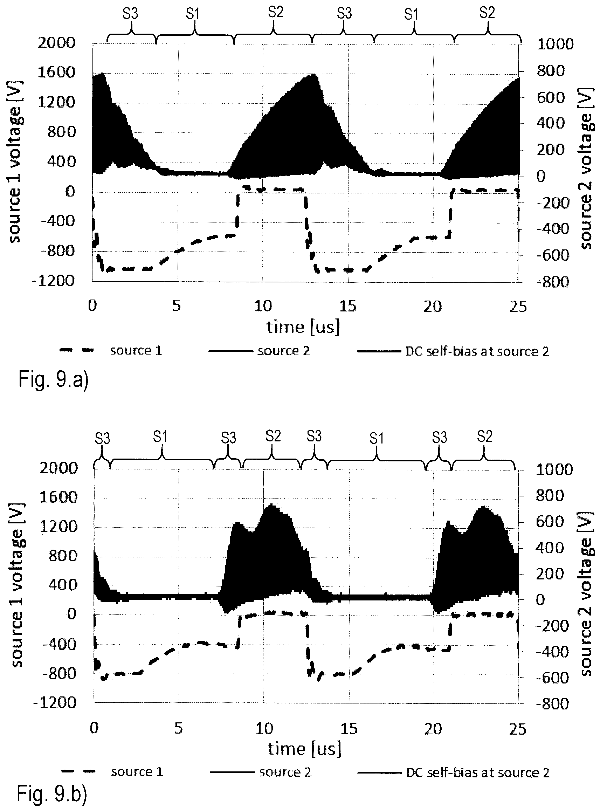

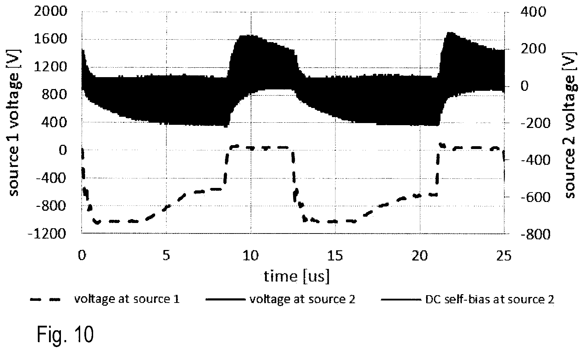

Fig. 9.a) and Fig. 9.b) show the time-dependency of voltages measured at the first and second source during two variants of the method, both of which are performed in an apparatus as shown in Fig. 8. For both variants, as well as for Fig. 10, the following applies. Source 1 voltage was measured by $U_{target}$. Its values in volt are plotted against the axis on the left as a dashed curve. Source 2 voltage was measured by $U_{rf}$. Its values in volt are plotted against the axis on the right of the figure a continuous black curve. Source 2 voltage is a rapidly oscillating rf voltage, such that the curve covers an area delimited by its amplitude. The DC self-bias $U_{DC}$ self-bias at source 2, i.e. a time-average of the rf voltage at source 2, is plotted as continuous grey curve. The horizontal axis displays the time in microseconds.

Fig. 9.a) shows the time-dependency of the voltages for a variant of the method, which implements the following sequence of states: S3 → S1 → S2 → S3 → S1 → S2 → S3 →... . Each of the three states prevail for about 4 microseconds. Both sources are operated in a pulsed way. In the first state S1 and the third state S3, the DC power supply delivers a negative voltage in the range of -400 V to -1 kV to the first plasma, i.e. it delivers the higher plasma supply power to the first plasma. In the second state, the DC power supply is switched off, such that source 1 voltage goes to approximately 0 V. In the second state S2 and the third state S3, the rf power supply delivers rf power, i.e. it delivers the higher plasma supply power to the second plasma. In the first state S1, the rf power supply is switched off. Amplitude and averaged rf voltage at the second source grow during the second state S2 and decrease in the third state S3. This change in the time-dependency is caused by the change from the lower power to the higher power at the side of the first source. As the inventors have recognized, a systematic drifting away of the operating parameters at the second source may be effectively reduced by synchronizing the pulsed operation of the second source with the pulsed operation of the first source.

Fig. 9.b) shows a variant of the method with slightly modified timing of the pulses as compared to Fig. 9.a).

Here, the rf pulse to the second source overlaps with the DC pulse to the first source at the beginning and at the end of the rf pulse, such that the following sequence of states results: S3 → S1 → S3 → S2 → S3 → S1 →... . With this sequence, rf amplitude and averaged rf voltage ramp up much faster at the beginning of the rf pulse and they decay much faster at the end of the rf pulse. In total, rf amplitude and averaged rf voltage, which both are operating parameters that have significant influence on the properties of the layers produced, can be kept close to a desired value over a relatively large fraction of the duration of the rf pulse.

Fig. 10 the time-dependency of voltages measured at the first and second source during a method according the state of the art performed in the same apparatus as the variants of the method described in the context of Fig. 9, but with a different timing scheme. Here, rf power is permanently on, whereas the DC power supply is pulsed. Accordingly, the following sequence of states results: S3 → S2 → S3 → S2 →... . The time course of the DC self-bias voltage is strongly affected by the pulsing on the DC power supply. The DC self-bias voltage even changes sign over time. In this method, the operating parameters of the second plasma source are close to their desired values only for a small fraction of the total operating time.

Typical operating parameters

Typical values of operating parameters, which may be combined with various of the embodiments as presented above, may be: pulse repetition rates of 50-100 kHz, duty cycles for pulsed DC power supplies 50% to 80% at power levels of 1 kW to 10 kW (or 1.5 to 15 W per cm2 of target surface area). For RF sources operating in a frequency range of 2-60 MHz (most common at 13.56 MHz) and at a power level of 1 - 10 kW, at voltage levels of 50 - 1000 V. Typical deposition rates are in the range of 0.1 - 10 nm/s. Typical times per deposition step range between a few seconds to about 60 minutes.

Example embodiment

In the following, an example embodiment combining specific features of several of the above-mentioned embodiments is discussed in further detail. Although more specific details are given for this example embodiment, reference signs match with Fig. 8.

A substrate 30 is placed on a carrier table, which forms a substrate holder 31 and which rotates underneath two sources, the first plasma source and the second plasma source. This way, the substrate is repetitively exposed to the coating environment of the first plasma source 12 and the plasma treatment environment of the second plasma source 22. A typical distance of 75 mm between the carrier table top surface and the target surface within the first source is used. A silicon target is installed at the first plasma source. The target rotates, and a typical magnetron type magnetic field configuration is generated by a static system of permanent magnets, located behind the back side of the target, for enhanced process rates and target material utilization. The method described here works no matter whether at the first plasma source 12 the target rotates, and the magnet arrangement does not, or the magnet arrangement rotates, and the target does not. A mixture of Argon gas and oxygen molecular gas is let into the vacuum chamber at the first plasma source. The oxygen gas flow is controlled by a feedback loop that regulates the oxygen gas flow to keep the potential of the target at a preset level. Typical gas flows are 35-45 sccm of Ar and 30-45 sccm of oxygen at the first plasma source. The first plasma source is operated with 5-6 kW of DC power, pulsed at a frequency of 80 kHz and a duty cycle of 68% (12.5 us period, 8.5 us "on time", 4 us "off time"). The resulting layer at the substrate surface consists of silicon dioxide. The layer is deposited at a typical deposition rate of 0.25-0.5 nm/s. In addition, 10 sccm of oxygen gas is introduced at the second plasma source 22. The second plasma source is operated using RF power at 13.56 MHz with power levels of 1-2 kW (for comparison in state-of-the-art situation, continuously on) or 2-6 kW (according to the invention, pulsed operation at 80 kHz, 5 us on time). The pulsing cycles of the DC power at the first plasma source 12 and of the second plasma source driven by RF power, are synchronized, so that the relative timing of the on times of the two sources can be adjusted.

According to the example embodiment, a capacitively coupled plasma configuration is used as the second plasma source.

In this configuration the setup is asymmetric, i.e. the source consists of a powered surface area that is relatively large compared with the grounded surface area of the extraction grid (grey dashed line in Fig. 8), where the plasma flows from the second plasma source towards the substrate surface. Due to the asymmetric configuration, a DC self-bias (typically 100-1000V) develops and the plasma potential inside the plasma source is high, leading to sufficiently high energies of a fraction of the ions reaching the substrate underneath the source to facilitate the desired surface treatment (e.g. smoothening of the growing layer). A static magnetic field generated by DC powered coils around the plasma source or by permanent magnets may be used to further optimize the plasma potential and the spatial distribution of the active species leaving the plasma source at the extraction grid.

In this example embodiment the lower plasma supply power delivered to the second plasma corresponds typically to <10% of the higher plasma supply power delivered to the second plasma. It may be as low as zero power. This lower plasma supply power delivered to the second plasma is activated during the "on time" of the pulsed DC power at the first plasma source. A relatively high power level (typically 1-10kW, high compared to a known continuous operation of a plasma source with a constant power level) is applied during the "off time" of the pulsed DC power at the first plasma source.

If, contrary to the method of the present invention, the first plasma source is pulsed, and the second plasma source is continuously active, a coupling between the plasmas generated at the two sources during the "on time" of the first plasma source disturbs the potential distribution. As a result, the RF period averaged potential at the powered electrode of the second plasma source, also known as the DC self-bias voltage, is strongly reduced (it even becomes negative in the present example, see Fig. 10), and the process does not run under the desired conditions, i.e. the energy of the ions reaching the substrate is insufficient, and charged species of the plasma at the first plasma source are drawn towards the second plasma source. According to the example embodiment, however, the first source is kept in pulsed operation and the second plasma source is changed to be in pulsed operation, as well (see Fig.9.a) and Fig. 9.b).

The timing of the DC pulse at the first plasma source and the RF pulse at second plasma source is synchronized, so that a fixed, but adjustable delay between an on time of the first and second plasma source is defined. A synchronization may be accomplished as follows. The DC power supply generates a TTL high signal at the beginning of $T_{DCon}$, which triggers a synchronization unit 32. In the synchronization unit, a TTL high signal with length $T_{RFon}$ is send to the RF power supply after an adjustable delay $T_{delay}$. Due to the maximum off time of the specific DC generator at the first plasma source (4 us) used here and the minimum on time of the specific RF generator at the second plasma source (5 us) used here, there must be an overlap. The power timing scheme as shown in Fig. 6 without an overlap and as shown in Fig. 7 with an overlap, may be applied.

Typical values for the timing and the power levels at the first plasma source are: 1-15 us for the "on time" ("TDCon") and for the "off time" ("TDCoff"), pulse repetition cycles ("TDCon"+"TDCoff") of 2-20 us (or pulse frequencies of 50-100 kHz), duty cycles ("TDCon"/ ("TDCon"+"TDCoff")) of 50-80%, power levels of 1-10kW (or 1.5-15 W per cm2 of target surface area). The delay "Tdelay" is set equal to "TDCon" (no overlap at the beginning of the RF pulse) or slightly (about 1 us) shorter than "TDCon" (overlap at the beginning of the RF pulse). The RF pulse is on ("TRFon") for a time equal or very similar to "TDCoff" and off ("TRFoff") for a time equal or very similar to "TDCon". The method considered here works with and without such an overlap, and it also works without an overlap and using a time TRFon smaller than TDCoff, so that none of the two sources is powered for a small fraction of the time period. An overlap of the pulses may actually facilitate a faster plasma ignition at the second plasma source.

With the method according to the example embodiment, the following improvements could be observed. For a SiO2 layer (with a thickness of 600 nm) deposited in the present example, we observe a reduction of the surface roughness (Rq value) from about 1.8 nm with the second plasma source turned off to below 0.5 nm with the plasma source turned on at the optimum conditions, i.e. pulsed at 6 kW RF power with a short overlap of the two pulses. The deposition rate was between 0.4 nm/s and 0.5 nm/s on 16 wafers of 200 mm diameter placed on the rotating carrier table. At the same time, the optical losses are reduced from more than 6% to less than <0.1% (measured at a wave-length of 300 nm).

The described method may be used in one or multiple process steps of an optical coating consisting of one or multiple layers of different materials (using multiple sputter source in a process sequence). The method may be applied to the vacuum deposition of dielectric coatings for various applications, such as gap filling on high aspect ratio structured wafers in semiconductor manufacturing. If the first plasma source is operated using DC pulsed and superimposed RF power or even using only RF power, the same method described above can be applied. Then, the pulsing scheme of the RF power at the first plasma source must be identical with the scheme for the DC pulsed power as described above. In such cases, it is possible to use one RF power supply for each of the first plasma source and for the second plasma source. Alternatively, it is possible to use a single RF power supply and to switch the output power repetitively between the first and second plasma source (in this case without an overlap between the "on" times).

The method according to the invention may be used with the first plasma source being supplied by a HiPIMS (High-power impulse magnetron sputtering) power supply, where short pulses (typically 50 us - 500 us) with high power densities at the target surface (on the order of kW per cm², two orders of magnitude above the conventional sputter deposition) are applied at low pulse frequencies (typically 100 Hz - 500 Hz). As the duty cycle is small (typically below 10%), the time averaged power stays similar to the conventional sputter deposition, making HiPIMS feasible with the same source hardware. In HiPIMS sputtering, most of the sputtered material is ionized, leading to a metal based plasma and improved control of substrate surface bombardment with kinetic metal particles. This allows for a tuning of film characteristics, such as smoothness, density and structure. Using the operating scheme with HiPIMS utilized at the first plasma source, the duty cycle at the second plasma source may be increased according to the reduced duty cycle of the first plasma source, and/or the times of low power supplied to both sources (state S4) may be increased. The lower pulse frequencies in combination with longer duty cycles at plasma source 2 leads to a stable DC self-bias over a larger fraction of the duty cycle, thereby allowing for an advanced tailoring of the ion energy distribution/ion current distribution at lower peak rf power values. This may result in improved surface treatment conditions and improved source hardware lifetime.

List of reference signs

| 1 | Vacuum chamber |
| 2 | plasma environment |
| 10 | first treatment area |
| 11 | first plasma (of a material deposition source) |
| 12 | first plasma source |
| 13 | first electric plasma supply arrangement |
| 20 | second treatment area |
| 21 | second plasma (of a non-deposition source) |
| 22 | second plasma source |
| 23 | second electric plasma supply arrange- |

| | ment |
| 30 | substrate |
| 31 | substrate holder |
| 32 | synchronization unit |
| 33 | weak plasma |
| P1 | power supplied to first plasma |
| P2 | power supplied to second plasma |
| S1 | first state |
| S2 | second state |
| S3 | third state |
| S4 | fourth state |
| ST | transitional power state |
| T | period |
| $T_{DCon}$ | time during which DC power supply is on |
| $T_{DCoff}$ | time during which DC power supply is off |
| $T_{RFon}$ | time during which RF power supply is on |
| $T_{RFoff}$ | time during which RF power supply is off |
| t1 | first time span during which the first state prevails |
| t2 | second time span during which the second state prevails |
| t3 | third time span during which the third state prevails |
| t4 | fourth time span during which the fourth state prevails |
| Δ | time lag |
| HIGH / LOW | indication of plasma supply power state |
| ON / OFF | indication of plasma supply power state |
| $U_{target}$ | target voltage |
| $U_{rf}$ | rf voltage |
| $U_{DC}$ | self-bias self-bias voltage |

Claims

1. Method of vacuum-treating a substrate or of manufacturing a vacuum-treated substrate, the method comprising the steps:

- providing a vacuum chamber (1),
- providing at least one substrate (30) in said vacuum chamber,
- generating a plasma environment (2) in said vacuum chamber and exposing said at least one substrate to said plasma environment, wherein said plasma environment comprises a first plasma (11) of a material deposition source and a second plasma (21) of a non-deposition source;

characterized in that the method comprises

- operating said plasma environment (2) repeatedly between a first and a second state, said first state (S1) being defined by: a higher plasma supply power to said first plasma causing a higher material deposition rate and a lower plasma supply power delivered to said second plasma,

said second state (S2) being defined by:
a lower plasma supply power to said first plasma, compared with said higher plasma supply power to said first plasma and causing a lower material deposition rate and a higher plasma supply power to said second plasma, compared with said lower plasma supply power to said second plasma.

2. The method of claim 1 comprising maintaining at least a part of said at least one substrate in said plasma environment (2) while moving said at least one substrate relative to said plasma environment.

3. The method of any one of claims 1 to 2, operating said plasma environment (2) periodically repeatedly between said first and said second state, with a varying or constant period and wherein said period T is selected to be: 2 psec ≤ T ≤ 50 psec.

4. The method according to any one of claims 1 to 3, comprising operating of said plasma environment (2) additionally in a third state being defined by simultaneously delivering said higher plasma supply power to said first plasma and said higher plasma supply power to said second plasma.

5. The method according to any one of claims 1 to 4, comprising exposing a first treatment area (10) for said substrate in said plasma environment (2) at least predominantly to said first plasma and exposing a second treatment area (20) for said substrate in said plasma environment at least predominantly to said second plasma.

6. The method according to any one of claims 1 to 5 comprising exposing a first treatment area (10) for said substrate in said plasma environment (2) at least predominantly to said first plasma and exposing a second treatment area (20) for said substrate in said plasma environment at least predominantly to said second plasma and positioning simultaneously a first part of said at least one substrate exclusively in said first treatment area (10) and a different, second part of said at least one substrate exclusively in said second treatment area (20).

7. The method of claim 6 comprising positioning a further different part of said at least one substrate in an overlapping area of said first (10) and second (20) treatment areas.

8. The method according to any one of claims 1 to 7 comprising exposing a first treatment area (10) for said substrate in said plasma environment (2) at least predominantly to said first plasma and exposing a second treatment area (20) for said substrate in said plasma environment at least predominantly to said second plasma and positioning simultaneously a part of a first substrate exclusively in said first treatment area and a part of a second substrate exclusively in said second treatment area.

9. The method of any one of claims 1 to 8, comprising operating said plasma environment (2) periodically repeatedly between said first (S1) and said second (S2) state, with a varying or constant period T, and wherein a first duty cycle DC1 defined as the ratio of time span during which the first state is enabled and said period of said operating, is kept within the range: 25% ≤ DC1 ≤ 90%.

10. The method of any one of claims 1 to 9, comprising operating said plasma environment (2) periodically repeatedly between said first (S1) and said second state (S2), with a varying or constant period T, and wherein a second duty cycle DC2 defined as the ratio of time span during which the second state is enabled and said period of said operating, is kept within the range: 25% ≤ DC2 ≤ 95%.

11. The method of any one of claims 1 to 10 comprising exposing a first treatment area (10) for said substrate in said plasma environment (2) at least predominantly to said first plasma and exposing a second treatment area (20) for said substrate in said plasma environment at least predominantly to said second plasma and establishing a gas atmosphere in said first and second treatment areas comprising equal gas or gases or consisting of equal gas or gases.

12. A vacuum deposition apparatus comprising:

- a vacuum chamber (1), in said vacuum chamber a material deposition first treatment area (10) and a material non-deposition second treatment area (20),
- a drivingly movable substrate holder (31) at least one of movable between said first treatment area and said second treatment area and of movable within at least one of said first treatment area and said second treatment area,
- a first plasma source (12) generating a first plasma (11) at least predominantly in said first treatment area,
- a second plasma source (22) generating a second plasma (21) at least predominantly in said second treatment area,
- a controllable first electric plasma supply arrangement (13), operationally connected to said first plasma source comprising a first control input to control different supply power levels,
- a controllable second electric plasma supply arrangement (23) operationally connected to said second plasma source and comprising a second control input to control different supply power levels, and
- a control arrangement operationally connected to said control inputs,

wherein said control arrangement is constructed to first control via said first control input said first electric plasma supply to repeatedly supply a first higher, plasma sustaining power level and a first lower power level,

wherein said control arrangement is constructed to second control via said second control input said second electric plasma supply to repeatedly supply a second higher, plasma sustaining power level and a second lower power level, and wherein said control arrangement is further constructed to time-synchronize said first and second controls,

**characterized in that**
said control arrangement is adapted and configured to synchronize an operating between a first state and a second state of the method as claimed in any one of claims 1 to 11.

13. The vacuum deposition apparatus of claim 12, wherein said first (10) and second (20) treatment areas are a common area, or wherein said first and second treatment areas overlap, or wherein said first and second treatment areas are in open communication.

14. Vacuum deposition apparatus according to claim 12 or 13, wherein there is valid at least one of:

- said first electric plasma supply arrangement is a controlled DC power supply arrangement,
- said second power supply is a controlled RF power supply.

15. Vacuum deposition apparatus according to one of claims 12 to 14, wherein said control arrangement controls a temporal overlap of said first higher power level and of said second lower power level and a temporal overlap of said first lower power level and of said second higher power level.

16. Vacuum deposition apparatus according to any one of claims 12 to 15, wherein said first plasma source is a pulsed DC magnetron source, in particular a pulsed DC magnetron source with superimposed RF.

17. Vacuum deposition apparatus according to any one of claims 12 to 16, wherein said first plasma source comprises a rotatable magnet arrangement and/or a rotatable target.

**Patentansprüche**

1. Verfahren zur Vakuumbehandlung eines Substrats oder zur Herstellung eines vakuumbehandelten Substrats, wobei das Verfahren die folgenden Schritte beinhaltet:

- Bereitstellen einer Vakuumkammer (1),
- Bereitstellen mindestens eines Substrats (30) in der Vakuumkammer,
- Erzeugen einer Plasmaumgebung (2) in der Vakuumkammer und Aussetzen des mindestens einen Substrats gegenüber der Plasmaumgebung, wobei die Plasmaumgebung ein erstes Plasma (11) einer Materialabscheidungsquelle und ein zweites Plasma (21) einer Nicht-Abscheidungsquelle umfasst;

**dadurch gekennzeichnet, dass** das Verfahren Folgendes umfasst

- Betreiben der Plasmaumgebung (2) wiederholt zwischen einem ersten und einem zweiten Zustand,
wobei der erste Zustand (S1) durch Folgendes definiert ist:
eine höhere Plasmaversorgungsleistung für das erste Plasma, wodurch eine höhere Materialabscheidungsrate bewirkt wird, und eine niedrigere Plasmaversorgungsleistung, die an das zweite Plasma abgegeben wird,
wobei der zweite Zustand (S2) durch Folgendes definiert ist:
eine niedrigere Plasmaversorgungsleistung für das erste Plasma, im Vergleich zu der höheren Plasmaversorgungsleistung für das erste Plasma, und Bewirken einer niedrigeren Materialabscheidungsrate und eine höhere Plasmaversorgungsleistung für das zweite Plasma, im Vergleich zu der niedrigeren Plasmaversorgungsleistung für das zweite Plasma.

2. Verfahren nach Anspruch 1, umfassend Halten mindestens eines Teils des mindestens einen Substrats in der Plasmaumgebung (2), während das mindestens eine Substrats relativ zu der Plasmaumgebung bewegt wird.

3. Verfahren nach einem der Ansprüche 1 bis 2, Betreiben der Plasmaumgebung (2) periodisch wiederholt zwischen dem ersten und dem zweiten Zustand mit einer variierenden oder konstanten Periode und wobei die Periode T so ausgewählt ist, dass sie wie folgt ist:

$$2\ \mu s \leq T \leq 50\ \mu s.$$

4. Verfahren nach einem der Ansprüche 1 bis 3, umfassend Betreiben der Plasmaumgebung (2) zusätzlich in einem dritten Zustand, der durch gleichzeitiges Abgeben der höheren Plasmaversorgungsleistung für das erste Plasma und der höheren Plasmaversorgungsleistung für das zweite Plasma definiert ist.

5. Verfahren nach einem der Ansprüche 1 bis 4, umfassend Aussetzen eines ersten Behandlungsbereichs (10) für das Substrat in der Plasmaumgebung (2) mindestens überwiegend gegenüber dem ersten Plasma und Aussetzen eines zweiten Behandlungsbereichs (20) für das Substrat in der Plasmaumgebung mindestens überwiegend gegenüber dem zweiten Plasma.

6. Verfahren nach einem der Ansprüche 1 bis 5, umfassend Aussetzen eines ersten Behandlungsbereichs (10) für das Substrat in der Plasmaumgebung (2) mindestens überwiegend gegenüber dem ersten Plasma und Aussetzen eines zweiten Behandlungsbereichs (20) für das Substrat in der Plasmaumgebung mindestens überwiegend gegenüber dem zweiten Plasma und gleichzeitiges Positionieren eines ersten Teils des mindestens einen Substrats ausschließlich im ersten Behandlungsbereich (10) und eines anderen, zweiten Teils des mindestens einen Substrats ausschließlich im zweiten Behandlungsbereich (20).

7. Verfahren nach Anspruch 6, umfassend Positionieren eines weiteren anderen Teils des mindestens einen Substrats in einem Überlagerungsbereich des ersten (10) und des zweiten (20) Behandlungsbereichs.

8. Verfahren nach einem der Ansprüche 1 bis 7, umfassend Aussetzen eines ersten Behandlungsbereichs (10) für das Substrat in der Plasmaumgebung (2) mindestens überwiegend gegenüber dem ersten Plasma und Aussetzen eines zweiten Behandlungsbereichs (20) für das Substrat in der Plasmaumgebung mindestens überwiegend gegenüber dem zweiten Plasma und gleichzeitiges Positionieren eines Teils eines ersten Substrats ausschließlich im ersten Behandlungsbereich und eines Teils eines zweiten Substrats ausschließlich im zweiten Behandlungsbereich.

9. Verfahren nach einem der Ansprüche 1 bis 8, umfassend Betreiben der Plasmaumgebung (2) periodisch wiederholt zwischen dem ersten (S1) und dem zweiten (S2) Zustand mit einer variierenden oder konstanten Periode T und wobei ein erster Arbeitszyklus DC1, der als das Verhältnis der Zeitspanne, während welcher der erste Zustand aktiviert ist, und der Periode des Betreibens definiert ist, innerhalb des folgenden Bereichs gehalten wird: $25\ \% \leq DC1 \leq 90\ \%$.

10. Verfahren nach einem der Ansprüche 1 bis 9, umfassend Betreiben der Plasmaumgebung (2) periodisch wiederholt zwischen dem ersten (S1) und dem zweiten (S2) Zustand mit einer variierenden oder konstanten Periode T und wobei ein zweiter Arbeitszyklus DC2, der als das Verhältnis der Zeitspanne, während welcher der zweite Zustand aktiviert ist, und der Periode des Betreibens definiert ist, innerhalb des folgenden Bereichs gehalten wird: $25\ \% \leq DC1 \leq 95\ \%$.

11. Verfahren nach einem der Ansprüche 1 bis 10, umfassend Aussetzen eines ersten Behandlungsbereichs (10) für das Substrat in der Plasmaumgebung (2) mindestens überwiegend gegenüber dem ersten Plasma und Aussetzen eines zweiten Behandlungsbereichs (20) für das Substrat in der Plasmaumgebung mindestens überwiegend gegenüber dem zweiten Plasma und Herstellen einer Gasatmosphäre in dem ersten und zweiten Behandlungsbereich, die gleiches Gas oder gleiche Gase umfasst oder aus gleichem Gas oder gleichen Gasen besteht.

12. Vakuumabscheidungsvorrichtung, umfassend

   - eine Vakuumkammer (1), wobei in der Vakuumkammer ein erster Materialabscheidungs-Behandlungsbereich (10) und ein zweiter Nicht-Materialabscheidungs-Behandlungsbereich (20) sind,
   - einen antriebsmäßig beweglichen Substrathalter (31), der mindestens eines von beweglich zwischen dem ersten Behandlungsbereich und dem zweiten Behandlungsbereich und von beweglich innerhalb von mindestens einem des ersten Behandlungsbereichs und des zweiten Behandlungsbereichs ist,
   - eine erste Plasmaquelle (12), die mindestens überwiegend in dem ersten Behandlungsbereich ein erstes Plasma (11) erzeugt,
   - eine zweite Plasmaquelle (22), die mindestens überwiegend in dem zweiten Behandlungsbereich ein zweites Plasma (21) erzeugt,
   - eine steuerbare erste elektrische Plasmaversorgungsanordnung (13), die mit der ersten Plasmaquelle wirkverbunden ist und einen ersten Steuereingang zum Steuern unterschiedlicher Versorgungsleistungspegel umfasst,
   - eine steuerbare zweite elektrische Plasmaversorgungsanordnung (23), die mit der zweiten Plasmaquelle wirkverbunden ist und einen zweiten Steuereingang zum Steuern unterschiedlicher Versorgungsleistungspegel umfasst, und
   - eine Steueranordnung, die mit den Steuereingängen wirkverbunden ist,

wobei die Steueranordnung angewiesen wird, über den ersten Steuereingang die erste elektrische Plasmaversorgung erstens so zu steuern, dass sie wiederholt einen ersten höheren, plasmaerhaltenden Leistungspegel und einen ersten niedrigeren Leistungspegel bereitstellt,

wobei die Steueranordnung angewiesen wird, über den zweiten Steuereingang die zweite elektrische Plasmaversorgung zweitens so zu steuern, dass sie wiederholt einen zweiten höheren, plasmaerhaltenden Leistungspegel und einen zweiten niedrigeren Leistungspegel bereitstellt,

wobei die Steueranordnung ferner angewiesen wird, die erste und zweite Steuerung zeitlich zu synchronisieren,

**dadurch gekennzeichnet, dass**

die Steueranordnung dazu ausgelegt und konfiguriert ist, ein Betreiben zwischen einem ersten Zustand und einem zweiten Zustand des Verfahrens nach einem der Ansprüche 1 bis 11 zu synchronisieren.

13. Vakuumabscheidungsvorrichtung nach Anspruch 12, wobei der erste (10) und der zweite (20) Behandlungsbereich ein gemeinsamer Bereich sind oder wobei sich der erste und der zweite Behandlungsbereich überlagern oder wobei der erste und der zweite Behandlungsbereich in offener Kommunikation stehen.

14. Vakuumabscheidungsvorrichtung nach Anspruch 12 oder 13, wobei mindestens eines von Folgendem gültig ist:

    - die erste elektrische Plasmaversorgungsanordnung ist eine gesteuerte DC-Leistungsversorgungsanordnung,
    - die zweite Leistungsversorgung ist eine gesteuerte RF-Leistungsversorgung.

15. Vakuumabscheidungsvorrichtung nach einem der Ansprüche 12 bis 14, wobei die Steueranordnung eine zeitliche Überlagerung des ersten höheren Leistungspegels und des zweiten niedrigeren Leistungspegels und eine zeitliche Überlagerung des ersten niedrigeren Leistungspegels und des zweiten höheren Leistungspegels steuert.

16. Vakuumabscheidungsvorrichtung nach einem der Ansprüche 12 bis 15, wobei die erste Plasmaquelle eine gepulste DC-Magnetronquelle, insbesondere eine gepulste DC-Magnetronquelle mit darübergelegter RF, ist.

17. Vakuumabscheidungsvorrichtung nach einem der Ansprüche 12 bis 16, wobei die erste Plasmaquelle eine drehbare Magnetanordnung und/oder ein drehbares Ziel umfasst.

**Revendications**

1. Procédé pour traiter sous vide un substrat ou pour fabriquer un substrat traité sous vide, le procédé comprenant les étapes consistant à :

    - fournir une chambre à vide (1),
    - fournir au moins un substrat (30) dans ladite chambre à vide,
    - générer un environnement de plasma (2) dans ladite chambre à vide et exposer ledit au moins un substrat audit environnement de plasma, ledit environnement de plasma comprenant un premier plasma (11) d'une source de dépôt de matière et un deuxième plasma (21) d'une source de non-dépôt ;

    **caractérisé en ce que** le procédé consiste à :

    - faire fonctionner ledit environnement de plasma (2) de façon répétée entre un premier et un deuxième état,

    ledit premier état (S1) étant défini par :
    une puissance d'alimentation plasma supérieure audit premier plasma induisant un taux de dépôt de matière supérieur et une puissance d'alimentation plasma inférieure audit deuxième plasma, ledit deuxième état (S2) étant défini par :
    une puissance d'alimentation plasma inférieure audit premier plasma, comparée à ladite puissance d'alimentation plasma supérieure audit premier plasma, et induisant un taux de dépôt de matière inférieur, et une puissance d'alimentation plasma supérieure audit deuxième plasma, comparée à ladite puissance d'alimentation plasma inférieure audit deuxième plasma.

2. Procédé selon la revendication 1, consistant à maintenir au moins une partie dudit au moins un substrat dans ledit environnement de plasma (2) tout en déplaçant ledit au moins un substrat par rapport audit environnement de substrat.

3. Procédé selon l'une des revendications 1 à 2, consistant à faire fonctionner ledit environnement de plasma (2) périodiquement et de façon répétée entre ledit premier état et ledit deuxième état, avec une période qui varie ou une période constante et dans lequel ladite période T est choisie pour être :

$$2 \ \mu\text{sec} \leq T \leq 50 \ \mu\text{sec}.$$

**4.** Procédé selon l'une des revendications 1 à 3, consistant à faire fonctionner ledit environnement de plasma (2) en plus dans un troisième état défini en fournissant simultanément une puissance d'alimentation plasma supérieure audit premier plasma et ladite puissance d'alimentation plasma supérieure audit deuxième plasma.

**5.** Procédé selon l'une des revendications 1 à 4, consistant à exposer une première zone de traitement (10) pour ledit substrat dans ledit environnement de plasma (2) au moins de façon prédominante audit premier plasma et à exposer une deuxième zone de traitement (20) pour ledit substrat dans ledit environnement de plasma au moins de façon prédominante audit deuxième plasma.

**6.** Procédé selon l'une des revendications 1 à 5 consistant à exposer une première zone de traitement (10) pour ledit substrat dans ledit environnement de plasma (2) au moins de façon prédominante audit premier plasma, à exposer une deuxième zone de traitement (20) pour ledit substrat dans ledit environnement de plasma au moins de façon prédominante audit deuxième plasma, et à positionner simultanément une première partie dudit au moins un substrat exclusivement dans ladite première zone de traitement (10) et une deuxième partie différente dudit au moins un substrat exclusivement dans ladite deuxième zone de traitement (20).

**7.** Procédé selon la revendication 6 consistant à positionner une autre partie différente dudit au moins un substrat dans une zone de chevauchement de ladite première (10) et de ladite deuxième (20) zone de traitement.

**8.** Procédé selon l'une des revendications 1 à 7 consistant à exposer une première zone de traitement (10) pour ledit substrat dans ledit environnement de plasma (2) au moins de façon prédominante audit premier plasma, à exposer une deuxième zone de traitement (20) pour ledit substrat dans ledit environnement de plasma au moins de façon prédominante audit deuxième plasma et à positionner simultanément une partie d'un premier substrat exclusivement dans ladite première zone de traitement et une partie d'un deuxième substrat exclusivement dans ladite deuxième zone de traitement.

**9.** Procédé selon l'une des revendications 1 à 8, consistant à faire fonctionner ledit environnement de plasma (2) périodiquement et de façon répétée entre ledit premier état (S1) et ledit deuxième état (S2), avec une période qui varie ou une période constante T, et dans lequel un premier cycle de service DC1 défini comme le rapport de durée durant lequel le premier état est activé et ladite période dudit fonctionnement, est maintenu dans la plage : $25\% \leq DC1 \leq 90\%$.

**10.** Procédé selon l'une des revendications 1 à 9, consistant à faire fonctionner ledit environnement de plasma (2) périodiquement et de façon répétée entre ledit premier état (S1) et ledit deuxième état (S2), avec une période T qui varie ou une période T constante, et dans lequel un deuxième cycle de service DC2 défini comme le rapport de durée pendant lequel le deuxième état est activé et ladite période dudit fonctionnement, est maintenu dans la plage : $25\% \leq DC2 \leq 95\%$.

**11.** Procédé selon l'une des revendications 1 à 10 consistant à exposer une première zone de traitement (10) pour ledit substrat dans ledit environnement de plasma (2) au moins de façon prédominante audit premier plasma, à exposer une deuxième zone de traitement (20) pour ledit substrat dans ledit environnement de plasma au moins de façon prédominante audit deuxième plasma, et à établir une atmosphère de gaz dans ladite première et ladite deuxième zones de traitement comprenant un gaz ou des gaz identique(s) ou composée d'un gaz ou de gaz identique(s).

**12.** Appareil de dépôt sous vide comprenant :

- une chambre à vide (1), et dans ladite chambre à vide une première zone de traitement de dépôt de matière (10) et une deuxième zone de traitement de non-dépôt de matière (20),
- un support de substrat mobile par entraînement (31) au moins mobile entre ladite première zone de traitement et ladite deuxième zone de traitement et mobile dans au moins l'une de ladite première zone de traitement et ladite deuxième zone de traitement,
- une première source de plasma (12) générant un premier plasma (11) au moins de façon prédominante dans ladite première zone de traitement,
- une deuxième source de plasma (22) générant un deuxième plasma (21) au moins de façon prédominante dans ladite deuxième zone de traitement,
- un premier agencement d'alimentation plasma électrique réglable (13), raccordé de façon opérationnelle à ladite première source de plasma comprenant une première entrée de commande pour commander différents niveaux de puissance d'alimentation,
- un deuxième agencement d'alimentation plasma électrique réglable (23) raccordé de façon opérationnelle à ladite deuxième source plasma et comprenant une deuxième entrée de commande pour commander différents niveaux de puissance d'alimentation, et

- un agencement de commande raccordé de façon opérationnelle auxdites entrées de commande,

dans lequel ledit agencement de commande est conçu pour d'abord commander, via ladite première entrée de commande, ladite première alimentation plasma électrique pour fournir de façon répétée un premier niveau de puissance plasma durable supérieur et un premier niveau de puissance inférieur,

dans lequel ledit agencement de commande est conçu pour ensuite commander, via ladite deuxième entrée de commande, ladite deuxième alimentation plasma électrique pour fournir de façon répétée un deuxième niveau de puissance plasma durable supérieur et un deuxième niveau de puissance inférieur, et dans lequel ledit agencement de commande est en outre conçu pour synchroniser ladite première et ladite deuxième commandes,
**caractérisé en ce que** ledit agencement de commande est adapté et configuré pour synchroniser un fonctionnement entre un premier état et un deuxième état du procédé, tel que revendiqué dans l'une des revendications 1 à 11.

13. Appareil de dépôt sous vide selon la revendication 12, dans lequel ladite première zone de traitement (10) et ladite deuxième zone de traitement (20) sont une zone commune, ou dans lequel ladite première zone de traitement et ladite deuxième zone de traitement se chevauchent, ou dans lequel ladite première zone de traitement et ladite deuxième zone de traitement sont en communication ouverte.

14. Appareil de dépôt sous vide selon la revendication 12 ou 13, dans lequel on applique au moins un des principes suivants :

- ledit premier agencement d'alimentation plasma électrique est un agencement d'alimentation CC contrôlé,
- ladite deuxième alimentation électrique est une alimentation RF contrôlée.

15. Appareil de dépôt sous vide selon l'une des revendications 12 à 14, dans lequel ledit agencement de commande commande un chevauchement temporel dudit premier niveau de puissance supérieur et dudit deuxième niveau de puissance inférieur, et un chevauchement temporel dudit premier niveau de puissance inférieur et dudit niveau de puissance supérieur.

16. Appareil de dépôt sous vide selon l'une des revendications 12 à 15, dans lequel ladite première source de plasma est une source magnétron CC pulsée, en particulier une source magnétron CC pulsée avec RF superposée.

17. Appareil de dépôt sous vide selon l'une des revendications 12 à 16, dans lequel ladite première source plasma comprend un agencement d'aimants pivotant et/ou une cible pivotante.

Fig. 1

Fig. 2

Fig. 3.a)

Fig. 3.b)

Fig. 3.c)

Fig. 3.d)

Fig. 3.e)

Fig. 3.f)

Fig. 4

P2:  LOW  HIGH  LOW  HIGH  LOW

P1:  HIGH  LOW  HIGH  LOW  HIGH

time

S1    S2    S1    S2

**Fig. 5**

P2:  OFF  ON  OFF  ON  OFF

$T_{RFoff}$  $T_{RFon}$

P1:  ON  OFF  ON  OFF  ON

$T_{DCon}$  $T_{DCoff}$

time

$T_{delay}$

S1    S2    S1    S2

**Fig. 6**

P2:

OFF | ON | OFF | ON | OFF

$T_{RFoff}$ $T_{RFon}$

P1:

ON | OFF | ON | OFF | ON

$T_{DCon}$ $T_{DCoff}$

time

$T_{delay}$

S1 S3 S2 S3 S1 S3 S2

Fig. 7

DC power supply  ←  Synchronization  →  RF power supply

13 32 23

$U_{target}$

$U_{rf}, U_{DC\,self\text{-}bias}$

12 11 10 21 22

20

30 33 31 1 30

Fig. 8

Fig. 9.a)

Fig. 9.b)

Fig. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015110968 A